Europäisches Patentamt

European Patent Office

Office européen des brevets

(11) Publication number: **0 242 600**
**A2**

## EUROPEAN PATENT APPLICATION

(21) Application number: 87104092.9

(51) Int. Cl.4: **G06F 7/50**

(22) Date of filing: **20.03.87**

(30) Priority: **20.03.86 JP 60673/86**

(43) Date of publication of application:
**28.10.87 Bulletin 87/44**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Kamatani, Yukio**
**1-3 Egawa-sou 2-33-6 Minamikase**
**Saiwai-ku Kawasaki-shi Kanagawa-ken(JP)**
Inventor: **Sugiyama, Hisashi**
**B-216 Toshibakamioooka-ryo 2-14-1 Ookubo**
**Kounan-ku Yokohama-shi Kanagawa-ken(JP)**
Inventor: **Shimizu, Shoichi**
**2-21-2 Tenjin-cho**
**Fujisawa-shi Kanagawa-ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Carry look-ahead calculating method and circuits therefor.

(57) A carry look-ahead calculating method and carry look-ahead circuits for performing parallel calculations of two n-bit numbers through at least one carry look-ahead circuit in which each sum ($P_i \cdot \overline{G_i}$) of the i-th bit position of the numbers and generators and propators ($G_i + P_i.G_{i-1} + P_iP_{i-1}G_{i-2} + ... + P_iP_{i-1} ... P_2G_1$) and ($G_{i-1} + P_{i-1}.G_{i-2} + P_{i-1}.P_{i-2} G_{i-2} + P_{i-1}.P_{i-2} .... P_2G_1$) of each carry from lower bit positions are calculate respectively through a common gate circuit portion in accordance with the following generalized equations;

$$C_{i+1} = G_i + P_i.G_{i-1} + P_iP_{i-1}G_{i-2} + ... + P_iP_{i-1} ... P_2G_1 + P_i.P_{i-1} .... P_1 (G_0 + P_0.C_0)$$

$$S_i = (P_i.G_i) \oplus (G_{i-1} + P_{i-1}G_{i-2} + P_{i-1}P_{i-2}G_{i-3} + P_{i-1}P_{i-2} .... P_2G_1 + P_{i-1}P_{i-2} .... P_1(G_0 + P_0.C_0))$$

$$(n > i, i = 0, 1, 2, 3, .... n)$$

the remaining propagators ($P_iP_{i-2} .... P_1.(G_0 + P_0.C_0)$) and ($P_{i-1}P_{i-2} ... \underline{P_i} (G_0 + P_0.C_0)$) of carry $C_0$ from the equations are calculated in accordance with the conditions of $C_0$ through the remaining gate circuit portion; and the result of two calculations in produced from the carry look-ahead circuit at the same time in accordance with the two carry conditions of "0" and "I", thereby strikingly reducing the total number of gates in the carry look-ahead circuit (CLA).

FIG.6(a)

~ 100

FIG.6(b)

A₀~A₃    B₀~B₃

CLA 4C

S₀~S₀    S₀~S₃

# CARRY LOOK-AHEAD CALCULATING METHOD AND CARRY LOOK-AHEAD CIRCUITS

## BACKGROUND OF THE INVENTION

### Field of the Invention

The present invention relates to carry look-ahead calculating method and carry look-ahead circuits using the method, capable of performing a high speed carry calculation necessary for addition of two binary numbers, with the strikingly reduced number of gates in the carry look-ahead circuits.

### Description of the Prior Art

With the rapid development of digital techniques and their applications, researches and developments of adders, multipliers and latch circuits as basis circuit components or devices in the IC technique have also been developed rapidly. The ultimate objects or goals of these researches and developments will reside in achieving high speed operations and low consumption power of large scale integrated circuits. In order to realize the objects, various studies have been also promoted in the development of high performance elements in view of designs.

With respect to adder circuits, which are requisite basic devices in multipliers among basic devices, it is carry calculation that determines the operating speed, i.e., it becomes a determinative factor in view of the circuit designs.

As will be well-known, carry calculations are performed by carry look-ahead circuits recently, based on parallel calculations which will be described below. Supporsing now that addition of two four-bit binary numbers A and B should be performed, with a carry logic $C_o$ of one bit. The two n-bit numbers A and B are expressed by the following binary coded decimal (BCD) notation;

$$\begin{cases} A = A_o + A_1 . 2 + A_2 . 2^2 + A_3 . 2^3 \\ B = B_o + B_1 . 2 + B_2 . 2^2 + B_3 . 2^3 \end{cases}$$

Generally, the following two numbers are firstly calculated with respect to each bit of the numbers.

$$\begin{cases} P_i = A_i + B_i \\ G_i = A_i . B_i \quad (i = 0, 1, 2, 3 ....) \end{cases} \qquad \ldots\ldots (1)$$

Here, $P_i$ and $G_i$ are called "propagator" and "generator" of i-th bit, respectively and they have the following relashionship each other between the two factors;

$$\begin{cases} P_i + G_i = P_i \\ P_i . G_i = G_i \end{cases} \qquad \ldots\ldots (2)$$

or

$$A_i \oplus B_i = P_i . \overline{G_i} \qquad \ldots\ldots (3)$$

The sum of the two numbers of i-th bit and its carry $C_{i+1}$ will generally be expressed by the following equations;

$$\begin{cases} C_{i+1} = G_i + P_i \cdot Ci & \cdots\cdots (4) \\ S_i = A_i \oplus B_i \oplus C_i = (P_i \cdot \overline{G_i}) \oplus C_i \\ \qquad\qquad (i = 0, 1, 2, 3 \cdots\cdots) \end{cases}$$

If all of the bits of the two input numbers A and B can be referred to at the same time in parallel, $G_i$, $G_{i-1}$, $P_i$, and $P_{i-1}$ in the equation (4) can be sought from the equation (I) at the same time. Since a carry $C_i$ is the result of calculation of the preceding bit, however, the calculation of $C_{i-1}$ as well as $S_i$ can not be started calculating until the calculation of the preceding bits has been completed in view of the equation (4).

Now, when each case of i = 0, I, 2, 3 is calculated and then $C_1$, $C_2$, $C_3$ are deleted from the equations (4), it follows that;

$$\begin{cases} C_4 = G_3 + P_3 \cdot G_2 + P_3 P_2 G_1 + P_3 \cdot P_2 \cdot P_1 (G_0 + P_0 \cdot C_0) \\ S_0 = (P_0 \cdot \overline{G_0}) \oplus C_0 \\ S_1 = (P_1 \cdot \overline{G_1}) \oplus (G_0 + P_0 \cdot C_0) & \cdots\cdots (5) \\ S_2 = (P_2 \cdot \overline{G_2}) \oplus (G_1 + P_1 \cdot (G_0 + P_0 \cdot C_0)) \\ S_3 = (P_3 \cdot \overline{G_3}) \oplus (G_2 + P_2 \cdot G_1 + P_2 \cdot P_1 (G_0 + P_0 \cdot C_0)) \end{cases}$$

Each of the right side terms of the equations in equations (5) all includes bits of A, B, $C_0$ or only generators and propagators which can be calculated therefrom immediately. Namely, all of the five equations in (5) indicated above can start calculating in parallel at the same time. The general equations of the carry $C_{i+1}$ and the result of the sum $S_i$ in equation (5) can be expressed by the following equations;

$$C_{i+1} = G_i + P_i G_{i-1} + P_i \cdot P_{i-1} G_{i-2} + \cdots + P_i \cdot P_{i-1} \cdots P_2 G_1 + P_i \cdot P_{i-1} \cdots P_1 (G_0 + P_0 \cdot C_0) \qquad \cdots\cdots (5')$$

$$S_i = (P_i \cdot \overline{G_i}) \oplus (G_{i-1} + P_{i-1} G_{i-2} + P_{i-1} P_{i-2} G_{i-3} + \cdots + P_{i-1} P_{i-2} \cdots P_2 G_1 + P_{i-1} P_{i-2} \cdots P_1 (G_0 + P_0 \cdot C_0))$$

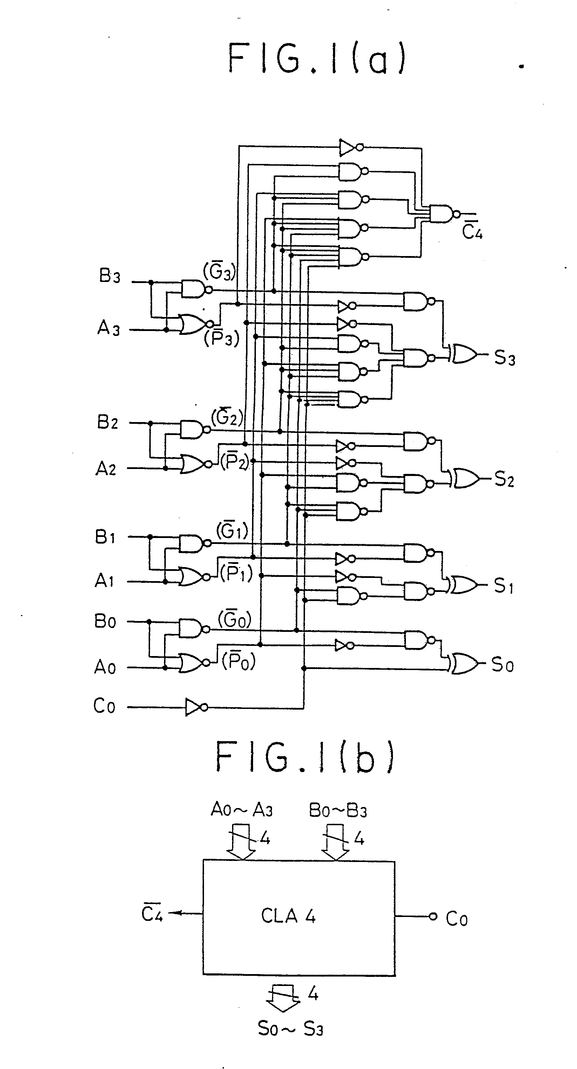

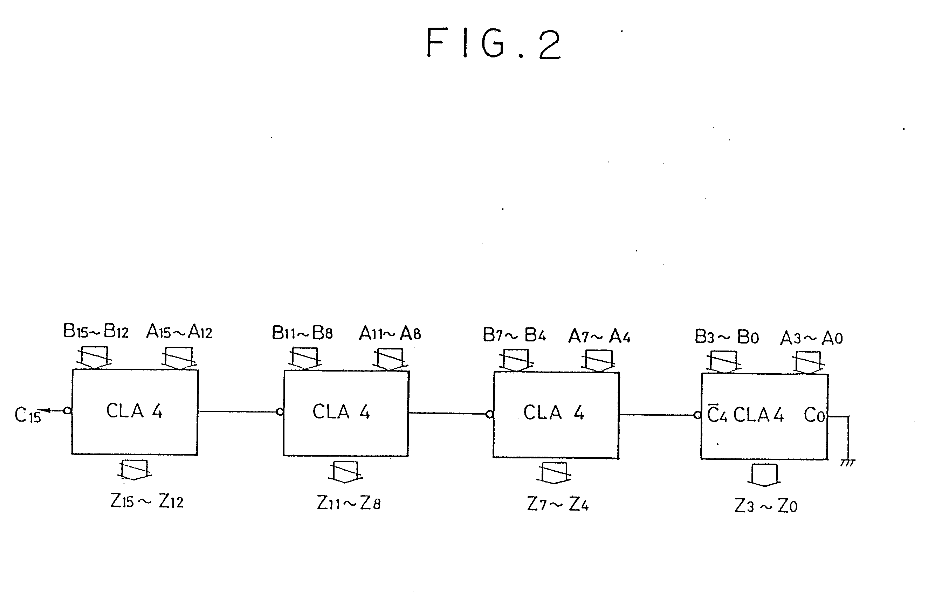

Fig. I(a) shows one example of a four-bit carry look-ahead circuit (which is referred to as "CLA" hereinafter) according to the prior art realized by various logic circuits and Fig. I(b) shows its simplifier symbolic notation. Additionally, in order to perform calculation of more than 4 bits, a high speed operation can be realized by using a necessary number of the 4-bit CLAs. For instance, when addition of two I6-bit numbers should be performed, the 4-bit CLAs may be arranged or connected in series as shown in Fig. 2. The total delay time $T_0$ of this adder circuit in this case becomes as follows;

(Delay time of one stage of CLA) $\times$ n (the number of stages) = $T_0$ ...... (6)

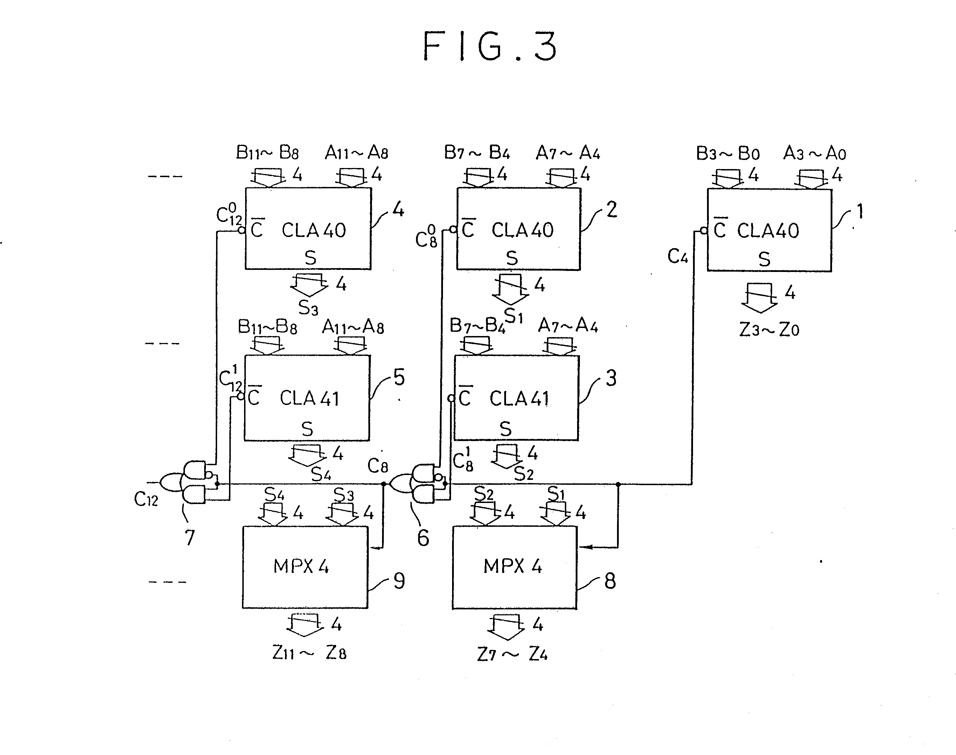

In order to realize a much more high speed operation, a carry selection circuit as shown in Fig. 3 has also been proposed heretofore. The basic design concept of this circuit is that two CLAs are provided for calculations of each carry since a carry from a preceding stage or stages is either a "0" or a "I" of the two binary bits, any suitable carry can be selected in accordance with the carry conditions from the preceding stage or stages of the CLAs, with each carry having been preliminarily calculated.

In Fig. 3, the CLAs 40 having reference numerals I, 2 and 4 are for calculations of each "0" carry while the CLAs 4I having reference numerals 3 and 5 are for the calculations of each "I" carry, respectively. Namely, each stage of the CLAs perform two ways of calculations of the "0" and "I" carries indicated such as $C_8 (= C_8^0, C_8^1)$ and $C_{12} (= C_{12}^0, C_{12}^1)$ with respect to the 5-th to 8th bit positions, and the 9-th to I2-th bit positions, etc.

The CLA 40(I) indicates the one for the 4-bit least significant digit positions. Since no carry is applied to its input in the 4-bit least significant digit positions, its carry is calculated in the CLA 40(I).

While the carry $C_4$ is being calculated in the CLA 40(I), other carries are being also calculated in the CLAs (2), (3), (4), (5) ... at the same time, so that each of the carries $C_4$, $C_8^0$, $C_8^1$, $C_{12}^0$, $C_{12}^1$, ... (i.e., $C_k^1$ indicates the carry of the k-th bit position, which is either "0" or "I" carry) can be calculated with the delay time of each stage of the CLAs.

3

Accordingly, whether "I" carry of $C_8^1$, or "0" carry of $C_8^0$ should be selected in the 8-th bit position for instance is determined by the operation of a multiplexer (6). In addition, the calculation result from $Z_4$ to $Z_7$ is also suitably selected from the result of the sum of the CLA 40(2) and CLA 4I(3) by the multiplexer (8) in accordance with the carry $C_4$. This holds true with the digit positions more than 8-th digit. As a result, the total time delay $T_0'$ for addition of 4n bits in this case becomes;

(Delay time of one stage of CLA) + (Delay time of one multiplexer) × n    ...... (7)

It will be appreciated that since the delay time of one multiplexer is much more short than that of the CLAs, a much more high speed carry operation can be achieved form the comparison of the equation (6) with the equation of (7). Moreover, since each carry of the inputs has been known about each of the CLAs 40 and 4I, some gates of the CLA can be simplified in accordance therewith. Namely, paying attention to the equation (2), since

$$G_0 + P_0 \cdot C_0 = \begin{cases} G_0 + P_0 = P_0 & (C_0 = 1) \\ G_0 & (C_0 = 0) \end{cases}$$

$G_0 + P_0 \cdot C_0$ of the equation (5) may be replaced with either $P_0$ or $G_0$ in accordance with the conditions of $C_0$.

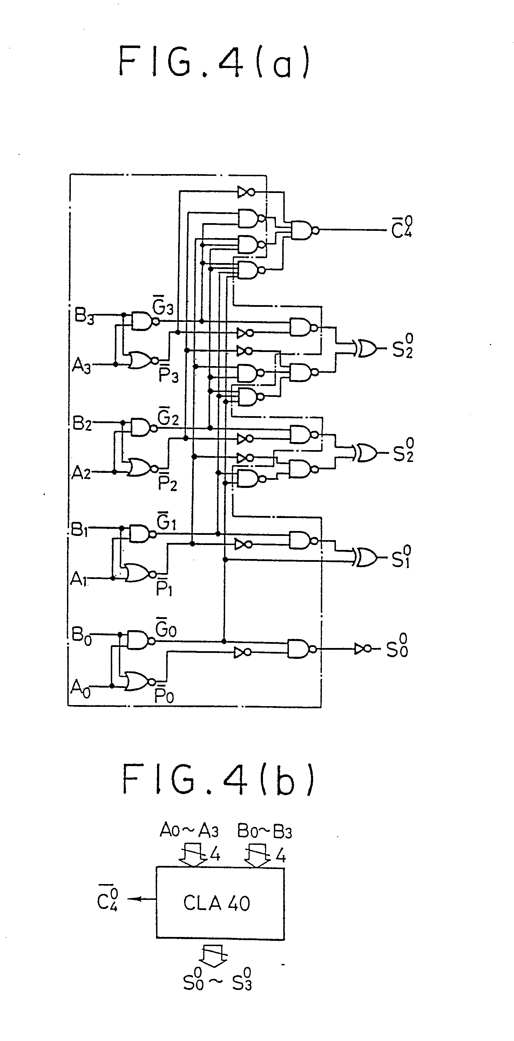

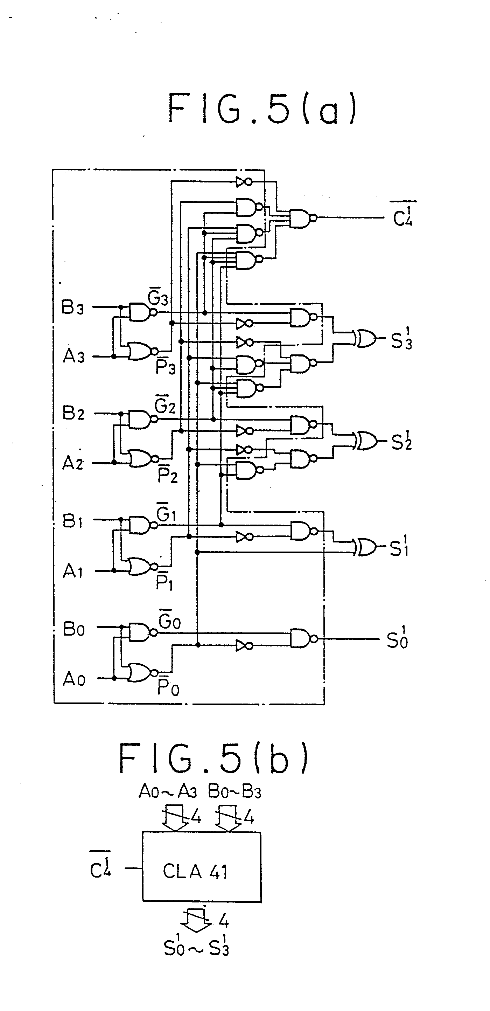

Figs. 4 and 5 show each construction of these circuits realized by this logic, which produce each sum $S_i^0$ of the input pairs in accordance with the "0" carry, and that $S_i^1$ of the input pairs in accordance with the "I" carry on the 4-th digit position, respectively.

The operation speed of these circuits has become high, to be sure. However, it is to be noted that the size of these circuits become twice higher than that of the series circuits of the CLAs shown in Figs. 2 and 3 when comparing the two circuits, thus making the circuit construction disadvantageous for miniturization as well as for realizing highly integrated circuits.


## SUMMARY OF THE INVENTION

It is therefore an object of the present invention to provide a carry look-ahead circuit capable of realizing low consumption power as well as less miniaturization of the IC circuits without reducing high operation performance of the carry selection system in adder circuits, but reducing the number of gates of the carry look-ahead circuits.

It is another object of the present invention to provide a carry look-ahead circuit capable of performing a high speed operation, with a strikingly reduced number of gates compared with that of the prior art.

It is still another object of the present invention to provide a carry look-ahead calculating method for performing parallel calculations of two n-bit numbers in which each sum of the i-th bit position and each carry consisting of generators and propagators from lower bit positions are calculated in a common gate circuit and the remaining propagators of each carry up to the i-th bit position in accordance with the conditions of $C_0$, so as to produce the result of two calculations at the same time in accordance with the bit conditions of the carry signal $C_0$.

One feature of the present invention resides in that a carry look-ahead circuit which executes parallel calculations for two n-bit numbers, possesses a circuit structure that will be shown below and outputs simultaneously results of addition for the two cases, 0 and I, of the state of signal $C_0$ of the carry from the lower bits. The fundamental characteristic of the structure is that it has a gate portion, inputs to which are constant irrespective of the state of the carry signal $C_0$ to the look-ahead cirduit that comes from the lower bits, as a common gate portion, and has two kinds of gate circuit portion, at least one input to which varies depending upon the changes in the state of $C_0$, in accordance with the two states, 0 and I, of $C_0$. Consider, for example, the case of calculating the carry from i-th bit and the addition for i-th bit that are shown by the following equations. In the calculation of $C_{i+1}$, $G_i$, $P_i \cdot G_{i-1}$, $P_i \cdot P_{i-1} \cdot G_{i-2}$, ..., and $P_i \cdot P_{i-1} \ldots P_2 \cdot G$, belong to the common gate circuit portion since they do not contain $C_0$. On the other hand, the $(i+I)$ - the input AND gate of $P_i \cdot P_{i-1} \ldots P_1 \cdot (G_0 + P_0 \cdot C_0)$, and the $(i+I)$ -th input OR gate which takes the logical sum of each terms in the expression just given, represent two kinds of gate circuit portions that correspond to the states $C_0 = 0$ and I. In addition, in the calculation for $S_i$, $P_i \cdot \overline{G_i}$, $G_{i-1}$, $P_{i-1} \cdot G_{i-2}$, ... $P_{i-1} P_{i-2} \ldots P_2 G$, belong to the common portion, while the i-th input AND gate $P_{i-1} \ldots P_i \cdot (G_0 + P_0 C_0)$, the i-th input OR gate which sums the terms $G_{i-1}$ through $P_{i-1} \ldots P_i \cdot (G_0 + P_0 C_0)$, and exclusive OR gate will have two kinds of value prepared.

$C_{i+1} = G_i + P_i G_{i-1} + P_i \cdot P_{i-1} G_{i-2} + P_i P_{i-1} \ldots P_2 G, + P_i \cdot P_{i-1} \ldots P_i \cdot (G_0 + P_0 \cdot C_0)$

0 242 600

$S_i = (P_i \bullet \overline{G_i}) \oplus (G_{i-1} + P_{i-1}G_{i-2} + P_{i-1}P_{i-2}G_{i-3} + P_{i-1}P_{i-2} .... P_2G_1 + P_{i-1}P_{i-2}P_{i-3} .... P_1(G_0 + P_0.C_0))$   (i = 0, 1, 2, 3 ....)

Another feature of the present invention resides in a carry look-ahead calculating method for performing parallel calculations of two n-bit numbers through at least one carry look-ahead circuit, which comprises the steps of: calculating each carry and sum of the i-th bit position of addition of the two n-bit numbers and generators and propagators of each carry from lower bit positions respectively through a common gate circuit in accordance with the following equations:

$$C_{i+1} = G_i + P_i G_{i-1} + P_i \cdot P_{i-1} G_{i-2} + P_i P_{i-1} \cdots$$
$$P_2 G_1 + P_i \cdot P_{i-1} \cdots P_1 \cdot (G_0 + P_0 \cdot C_0)$$

$$S_i = (P_i \cdot \overline{G_i}) \oplus (G_{i-1} + P_{i-1} \cdot G_{i-2} + P_{i-1} P_{i-2} G_{i-3} +$$
$$P_{i-1} \cdot P_{i-2} \cdots P_2 G_1 + P_{i-1} P_{i-2} P_{i-3} \cdots$$
$$P_1 (G_0 + P_0 \cdot C_0)) \qquad \cdots\cdots (\alpha)$$

or

$$\overline{C_{i+1}} = \overline{\overline{P_i} \cdot \overline{G_i} \cdot \overline{P_{i-1}}} \cdot \overline{\overline{G_i} \cdot \overline{G_{i-1}} \cdot \overline{P_{i-2}}} \cdots \overline{\overline{G_i} \cdot \overline{G_{i-1}} \cdots \overline{G_2} \cdot \overline{P_1}} \cdot$$
$$\overline{\overline{G_i} \cdot \overline{G_{i-1}} \cdot \overline{G_{i-3}} \cdots \overline{G_1} \ (\overline{G_0 + P_0 \cdot C_0})}$$

$$S_i = (\overline{P_i \cdot \overline{G_i}}) \oplus$$

$$(\overline{\overline{P_{i-1}} \cdot \overline{G_{i-1}} \cdot \overline{P_{i-2}} \cdot \overline{G_{i-1}} \cdot \overline{G_{i-2}}} \cdots \overline{P_{i-3} \cdot \overline{G_{i-1}} \cdot \overline{G_{i-2}}} \cdots \overline{G_2 P_1} \cdot \cdots (\beta)$$
$$\cdot \overline{\overline{G_{i-1}} \cdot \overline{G_{i-2}} \cdots \overline{G_1} \ (\overline{G_0 + P_0 \cdot C_0})})$$

calculating the remaining propagators of each carry from the above equations ($\alpha$) or ($\beta$) in accordance with the conditions of $C_0$ through another gate circuit: and producing the result of two calculations at the same time in accordance with the two carry conditions of "0" and "I" from the lower bit position $C_0$, thereby strikingly reducing the total number of gates in the carry look-ahead circuit.

These and other objects, features and advantages of the invention will be better understood from the following detailed description of the invention with reference to the accompanying drawings.


BRIEF DESCRIPTION OF THE DRAWING

Figs. I(a) and (b) show respectively a carry look-ahead circuit for addition of two 4-bit input numbers according to the prior art and its symbolic notation.

Fig. 2 is the construction of a high speed adder circuit for addition of two n-bit input numbers with a plurality of the carry look-ahead circuits connected in series, according to the prior art,

Fig. 3 is a high speed adder circuit for two n-bit numbers utilizing a carry selection method according to the prior art,

Figs. 4(a) and (b)show another high speed carry look-ahead circuit for addition of two 4-bit numbers when the carry condition is "0" and its symbolic notation, according to the prior art,

5

Figs. 5(a) and (b)show another high speed look-ahead circuit for addition of two 4-bit numbers when the carry condition is "I" and its symbolic notation, according to the peior art,

Fig. 6 is one embodiment of the carry look-ahead circuit for addition of two 4-bit numbers according to the present invention,

Fig. 7 is an high speed adder circuit for addition of two n-bit numbers with a plurality of the carry hook-ahead circuits of Fig. 6 connected in series, according to the present invention,

Fig. 8 is another carry look-ahead circuit of the prior art, realized in accordance with another logical condition,

Fig. 9 is another embodiment of the carry look-ahead circuit for addition of two 4-bit numbers according to the present invention, which corresponds to the circuit of Fig. 8,

Figs. I0(a) and (b) show respectively each detailed construction of NAND and NOR gate circuits formed by CMOS transistors for use in the carry look-ahead circuit according to the present invention, and

Figs. II(a) and (b) show respectively each detailed construction of NAND and NOR gate circuits formed by BI-CMOS transistors for use in the carry look-ahead circuit according to the present invention, and

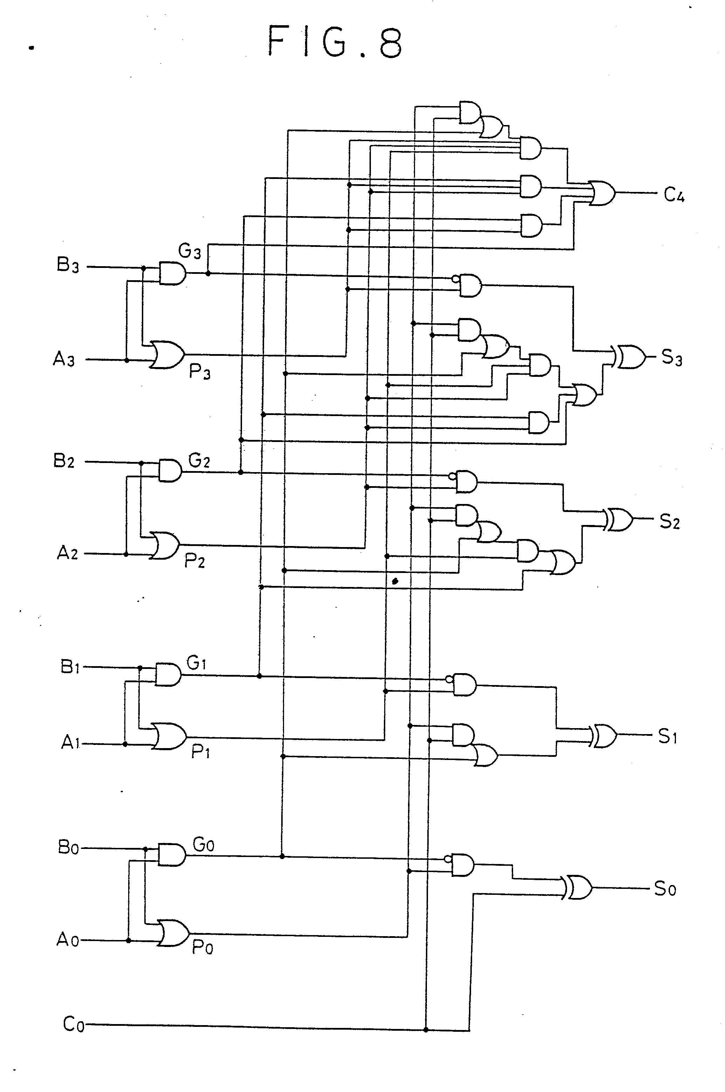

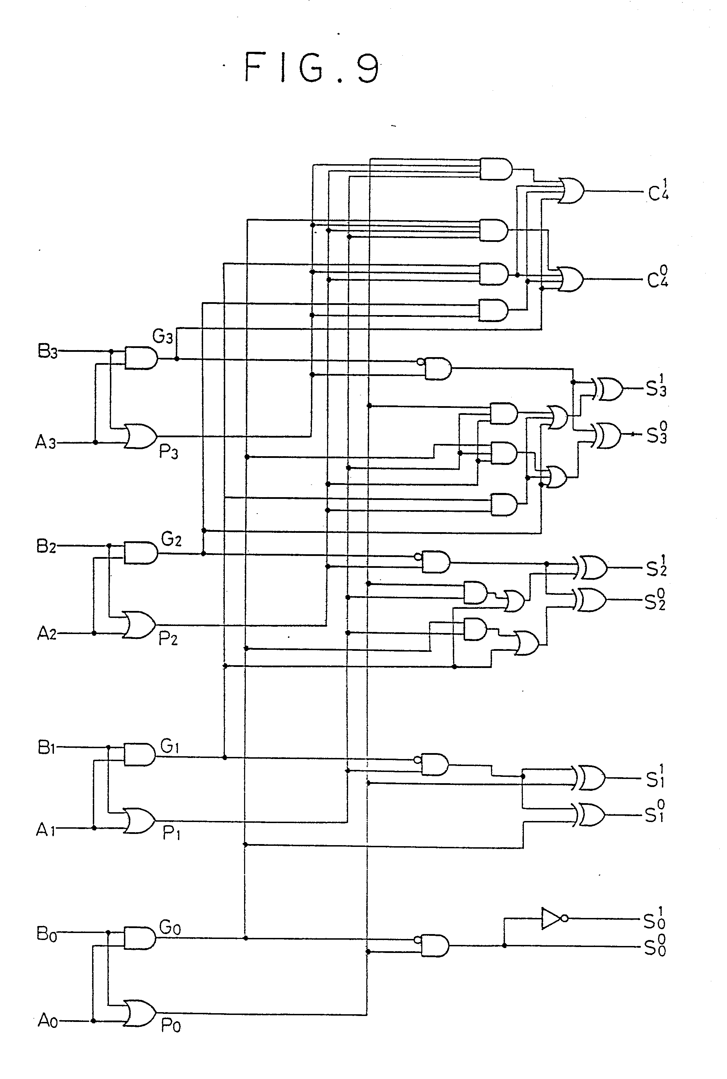

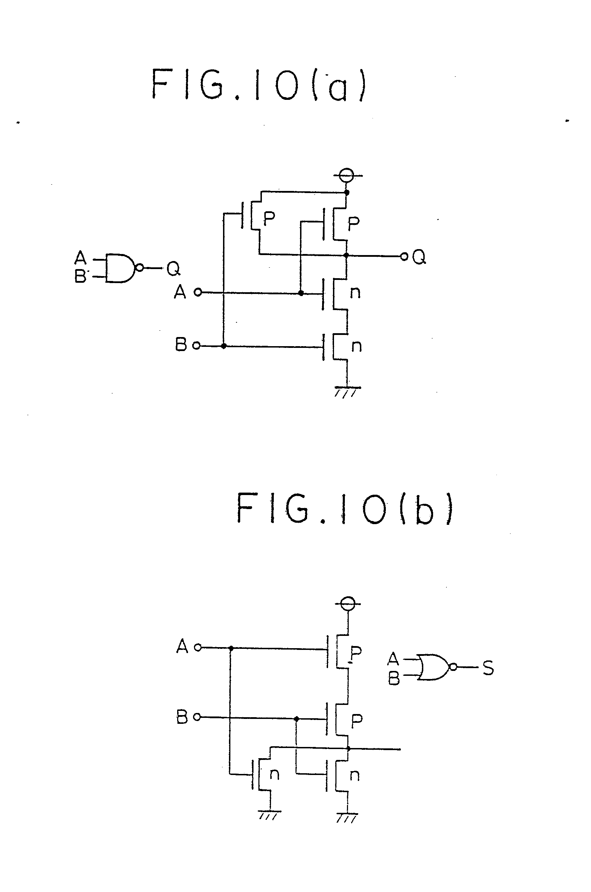

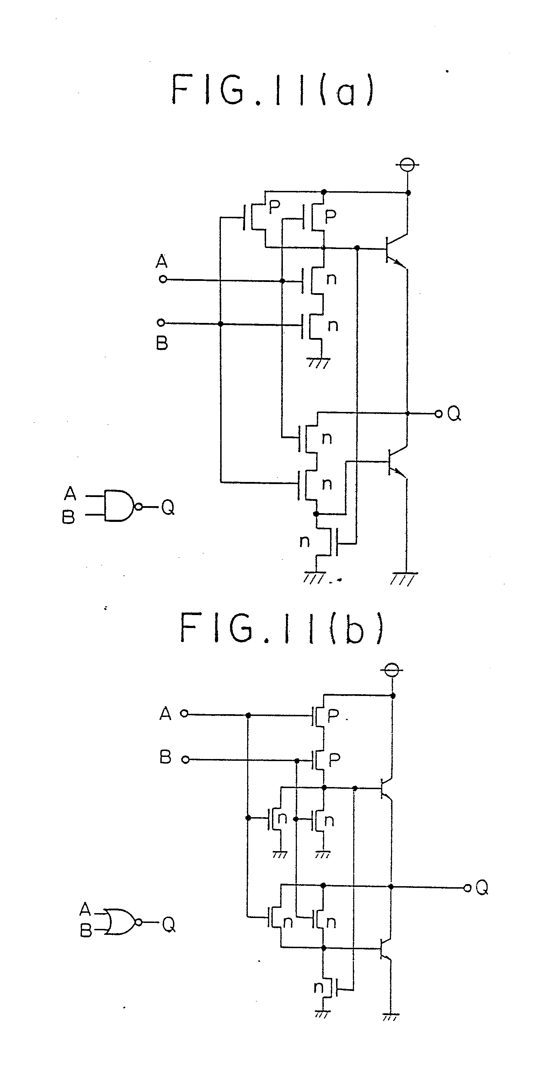

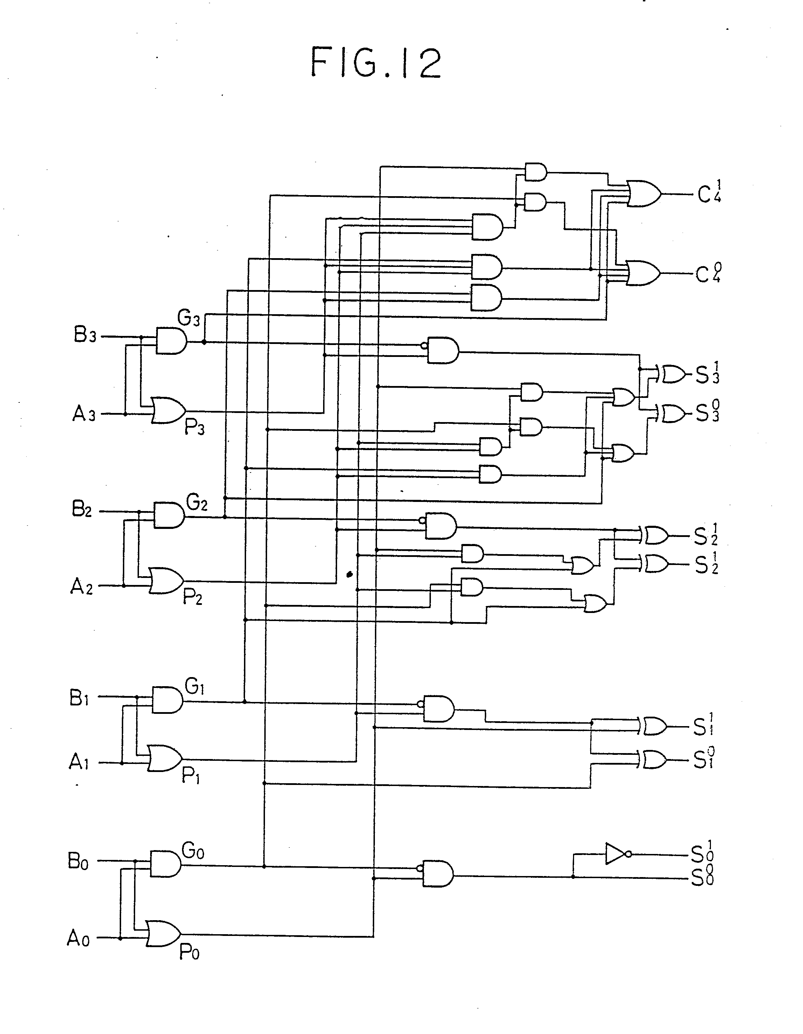

Fig. I2 is a diagram for a carry look-ahead circuit embodying the present invention for summing two 4-bit numbers that corresponds to the circuit in Fig. 8, but differs from that in Fig. 9.

## DESCRIPTION OF THE PREFERRED EMBODIMENT

Before describing the present invention, let us study the circuit constructions of Figs. 4 and 5 which show each of the 4-bit CLAs and which corresponds to the $C_0$ condition "0" or "I", respectively.

When comparing the two circuit constructions of Figs. 4 and 5, it will be appreciated that the portions encircled with a dot-dashed line in Figs. 4 and 5 completely coincide with each other. This gate circuit has a structure which is based upon equation ($\beta$). As may be seen from the expression for the equation, the structure is characterized in that there are included only ND gates (including inverters) and exclusive OR gates with respect to $P_i$ and $G_i$. (Note that in contrast to this, equation ($\alpha$) requires AND gates, OR gates, and exclusive LROR gates.)

Let us now consider the portions of Figs. 4 and 5 that are surrounded by the broken lines in relation to equation ($\beta$). First, regarding the carry ($C_4^0$, $C_4^1$) of output, the terms

$$\overline{\overline{G_i} \cdot \overline{P_{i-1}}}, \quad \ldots, \quad \overline{\overline{G_i} \cdot \overline{G_{i-1}} \cdots \overline{G_2} \cdot \overline{P_1}}$$

in the equation constitute the common portion. Next, regarding the summation ($S_i^0$, $S_i^1$) for each bit, the terms

$$\overline{\overline{P_i} \cdot \overline{G_i}}, \quad \overline{\overline{P_{i-1}}}, \quad \overline{\overline{G_{i-1}} \cdot \overline{P_{i-2}}}, \quad \ldots,$$

$$\overline{\overline{G_{i-1}} \cdot \overline{G_{i-2}} \cdots \overline{G_2} \cdot \overline{P_1}}$$

in the equation constitute the common portion. These represent the portions that are surrounded by the broken lines. Further, the portions outside of the broken lines correspond to the following expressions. Namely. for the carry portion is corresponds to the logic for

$$\overline{\overline{G_i} \cdot \overline{G_{i-1}} \cdots \overline{G_1} \cdot (\overline{G_0} + \overline{P_0} \cdot \overline{C_0})}$$

and the entire (i + I)-th input NAND. while for the sum portion it corresponds to

$$\overline{\overline{G_{i-1}} \cdot \overline{G_{i-2}} \cdots \overline{G_1} \cdot (\overline{G_0} + \overline{P_0} \cdot \overline{C_0})},$$

the i-th NAND in the right-hand term of the exclusive OR, and the exclusive OR. These will be realized as two kinds of gate circuits based on the relation $G_0 + P_0 \cdot C_0 = G_0$ and $P_0$ (for $C_0 = 0$ and I).

As described in the foregoing, the gate circuits in Figs. 4 and 5 each has a common portion whose value is constant regardless of the value of the carry signal $C_0$ from the outside, and a portion, whose input state varies depending upon $C_0$, that takes on different circuit structure in accordance with the value of $C_0$.

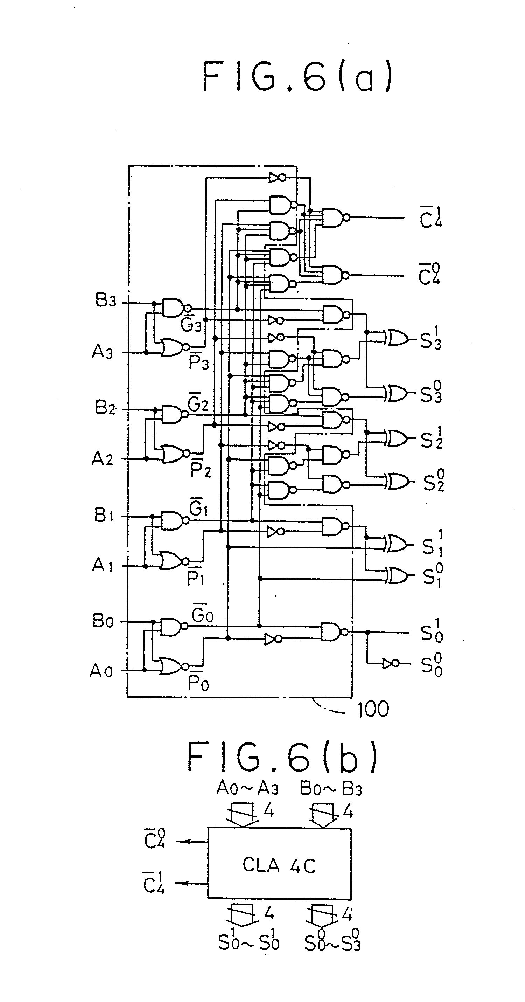

Figs. 6 (a) (b) show one embodiment of the 4-bit CLA having a common circuit portion I00 and the remaining portion for producing the result of two additions of each of bit positions and each carry according to the "0" and "I" conditions of $C_0$ of the present invention. Namely, Fig. 6 (a) shows a logical circuit construction of the CLA and Fig. 6 (b) shows its symbolic rotation of the CLA.

In Fig. 6 (a). it shows that the number of gates according to the prior art is reduced to 4I gates which is about 35%, compared with the number of the gates of Figs. 4 and 5 which have a sum of 63 gates in all with respect to the CLA 40 and CLA 4I, although the function of the CLA 4C in Figs. 6 (a) (b) according to the present invention is equal to the total function of the two CLAs of Figs. 4 and 5.

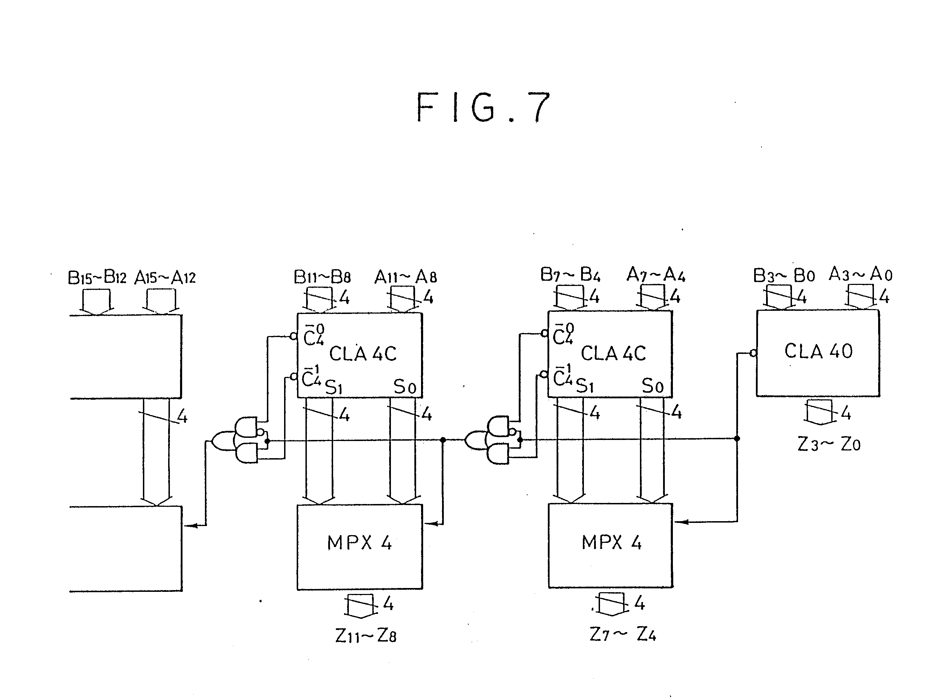

Fig. 7 shows the construction of a carry selection system using these CLA 4Cs which corresponds to that of Fig. 3, thus realizing the reduction in the number of gates as well as miniturization of the circuit construction.

Needless to say, it is also possible to apply the present invention to equation ($\alpha$). For instance, the logic for the carry look-ahead circuit for the case of n = 4 is as shown in equation (5).

Accordingly, its carry look-ahead circuit can also be constructed as shown in Fig. 8 according to the prior art. As a result, application of the present invention to the carry look-ahead circuit of Fig. 8 which has realized by the logical equations in (5), enable the circuit to be the one as shown in Fig. 9 by simplifying the common circuit portion of the gates, which shows another embodiment according to the present invention. Since the function of the circuit in Fig. 9 is similar to that of the circuit of Fig. 6, it will be not necessary to describe its operation much more.

In order to achieve a much more high speed operation of the CLAs in view of the circuit construction, NAND and NOR circuits for use in the CLAs may be realized by CMOS gates or Bi-CMOS gates, etc.

Figs. I0 (a) and (b) show respectively, embodiments of the NAND and NOR circuits realized by the CMOS transistors. In order to achieve the high speed operation, it is necessary for each of the CMOS to have a low output impedance respectively. To this end, the width of the gate of each of the CMOS transistors is widened and the length of the gates is also made short in these CMOS transistors.

Figs. II (a) and (b) show other embodiments of the NAND and NOR circuits realized by bipolar and CMOS transistors to be used for the CLAs in the present invention.

In the foregoing embodiments of carry look-ahead circuits according to the present invention, it is to be noted that even the propagators of $(P_i \cdot P_{i-1} \cdot P_{i-3} \ldots P_1)$ or

$$(\overline{\overline{G}_1 \cdot \overline{G}_{i-1} \cdot \overline{G}_{i-2} \cdots \overline{G}_1})$$

with respect to each carry signal can be made in common in the carry look-ahead circuits according to the present invention. In that case, only the calculation of

$$(G_0 + P_0 C_0) \quad \text{or} \quad (\overline{G_0 + P_0 C_0})$$

may be performed separately in accordance with the conditions of $C_0$.

Moreover, in the foregoing embodiments. the description has been made about two 4-bit numbers. However, it will be apparent that the carry look-ahead circuits are not limited to the 4-bit information and they can be expanded to other arbitrary input bit numbers.

As has been described in the foregoing embodiments according to the present invention. the number of gates can largely be reduced. compared with those according to the prior art. and the CLAs having a small size yet a low consumption power can be obtained.

While the invention has been described in its preferred embodiments, it is to be understood that the words which have been used are words of description rather than limitation and that various changes and modifications may be made within the purview of the appended claims without departing from the true scope and spirit of the invention in its broader aspects.

## Claims

I. A carry look-ahead calculating method for performing parallel calculations of at least two n-bit numbers in accordance with the following equations of .

$$\begin{cases} C_{i+1} = G_i + P_i \cdot C_i \\ S_i = A_i \oplus B_i \oplus C_i = (P_i \cdot \overline{G_i}) \oplus C_i \\ \qquad\qquad (n > i, \; i = 0, 1, 2, 3 \ldots) \end{cases}$$

where $A_i$ = one of said n-bit numbers (i-th bit)

$B_i$ = the other n-bit number (i-th bit)

$C_i$, $C_{i+1}$ = each carry

$G_i$ = generator of i-th bit ($A_i.B_i$)

$P_i$ = propagator of i-th bit ($A_i + B_i$)

, which comprises the steps of:

a) calculating each sum and carry of the i-th bit position consisting of generators and propagators from lower bit positions respectively through a common gate circuit;

b) calculating propgations of each carry up to to the i-th bit position in accordance with the conditions of $C_o$; and

c) producing the result of two calculations at the same time in accordance with the $C_o$ conditions of "0" and "I"

2. The carry look-ahead calculating method as claimed in claim I wherein the calculation of the propagations up to the i-th of each carry from the lower bit positions is calculated in the common gate circuit.

3. A carry look-ahead calculating method for performing parallel calculations of two n-bit numbers through at least one carry look-ahead circuit (CLA), which comprises the steps of:

a) calculating each sum of the i-th bit position of the two n-bit numbers and carry-generators and propagators from lower bit positions respectively through a common gate circuit portion, that is a gate set in which each gate is not under the influence of the $C_o$ condition, in accordance with the following equations:

$$C_{i+1} = G_i + P_i G_{i-1} + P_i \cdot P_{i-1} G_{i-2} + \ldots + P_i \cdot P_{i-1} \cdots P_2 G_1$$
$$+ P_i \cdot P_{i-1} \cdots P_1 (G_o + P_o \cdot C_o) \qquad \ldots (1)$$

$$S_i = (P_i \cdot \overline{G_i}) \oplus (G_{i-1} + P_{i-1} \cdot G_{i-2} + P_{i-1} P_{i-2} G_{i-3} +$$
$$P_{i-1} \cdot P_{i-2} \cdots P_2 G_1 + P_{i-1} P_{i-2} \cdots P_1 (G_o + P_o \cdot C_o))$$

or

$$C_{i+1} = \overline{\overline{P_i} \cdot \overline{G_i}} \cdot \overline{\overline{P_{i-1}} \cdot \overline{G_i} \cdot \overline{G_{i-1}} \cdot \overline{P_{i-2}}} \cdots \overline{\overline{G_i} \cdot \overline{G_{i-1}} \cdots \overline{G_2 P_1}} \cdot$$
$$\overline{\overline{G_i} \cdot \overline{G_{i-1}} \cdots \overline{G_1} \cdot (\overline{G_o + P_o \cdot C_o})} \qquad \ldots (2)$$

$$S_i = (\overline{P_i} \cdot \overline{G_i}) \oplus (\overline{\overline{P_{i-1}} \cdot \overline{G_{i-1}} \cdot \overline{P_{i-2}}} \cdot \overline{\overline{G_{i-1}} \cdot \overline{G_{i-2}} \cdot \overline{P_{i-3}}} \cdots$$
$$\overline{\overline{G_{i-1}} \cdot \overline{G_{i-2}} \cdots \overline{G_2} \cdot P_1} \cdot \overline{\overline{G_{i-1}} \cdot \overline{G_{i-2}} \cdots \overline{G_1} \cdot (\overline{G_o + P_o \cdot C_o})})$$

b) calculating the remaining ropagations from said equations (I) or (2) in accordance with the conditions of $C_o$ through the remaining gate circuit portion; and

c) producing the result of two calculations at the same time in accordance with the two carry conditions of "0" and "I" of $C_o$ bit, thereby strikingly reducing the total number of gates in the CLA.

4. The carry look-ahead calculating method as claimed in claim 3 wherein said two n-bit numbers are n = 4 bits respectively.

5. The carry look-ahead calculating method as claimed in claim 3 wherein the total number of gates in the CLA is 4I gates when n = 4 bits.

6. The carry look-ahead calculating method as claimed in claim 3 wherein said two n-bit numbers are n = I6 bits respectively.

7. The carry look-ahead calculating method as claimed in claim 3 wherein the steps of calculating said propagations from the lower bit positions among said equations (I) or (2) further comprises a step of calculating even said propagations from $c_o$bit through a common gate.

circuit and only the calculation with $(G_o + P_o.C_o)$ or

$$(\overline{G_o + P_o.C_o})$$

is performed by another gate circuit in accordance with the conditions of $C_o$.

8. The carry look-ahead calculating method as claimed in claim 3 wherein said carry generators and propagators from the lower bit positions are:

$$G_{i-1} + P_{i-1}.G_{i-2} + P_{i-1}.P_{i-2}.G_{i-3} + P_{i-1}.P_{i-2} \dots P_i.G_i$$

and said remaining propagators of each carry are:

$$P_{i-1}.P_{i-2}.P_{i-3} \dots P_i.(G_o + P_o.C_o)$$

when calculations for the sum and the carry at the i-th bit position are performed in accordance with the equation (I).

9. The carry look-ahead calculating method as claimed in claim 3 wherein said carry generators and propagators from the lower bit positions are:

$$(\overline{P_{i-1}}.\overline{G_{i-1}}.\overline{P_{i-2}} \cdot \overline{G_{i-1}}\,\overline{G_{i-2}}.\overline{P_{i-3}} \cdot \overline{G_{i-1}}\,\overline{G_{i-2}} \dots \overline{G_2 P_1})$$

and said remaining propagators of each carry are;

$$\overline{G_{i-1}}.\overline{G_{i-2}} \dots \overline{G_1}.(\overline{G_o + P_o \cdot C_o})$$

when calculations for the sum and carry at the i-th bit position are performed in accordance with the equation (2).

I0. The carry look-ahead calculating method as claimed in claim 3 wherein the gate circuits of the carry look-ahead circuit are CMOS gate circuits.

II. The carry look-ahead calculating method as claimed in claim 5 wherein the gate circuits of the carry look-ahead circuit are Bi-CMOS gate circuits.

I2. The carry look-ahead calculating method as claimed in claim II wherein the Bi-CMOS gate circuits are arranged to generate the generator and the propagator $(G_i, P_i)$.

I3. A carry look-ahead circuit for performing parallel calculations of two n-bit numbers, which comprises:

(a) a common gate circuit portion for calculating each sum of the i-th bit position of the two numbers and generators and propagators of each carry from lower bit positions respectively in accordance with the following equations of

$$C_{i-1} = G_i + P_iG_{i-1} + P_i.P_{i-1}G_{i-2} + \dots P_2G_i + P_i.P_{i-1} \dots P_i.(G_o + P_o.C_o)$$

$$S_i = (P_i . \overline{G_i}) \oplus (G_{i-1} + P_{i-1}.G_{i-2} + P_{i-1}.P_{i-2}G_{i-3} + P_{i-1}.P_{i-2} \dots P_2G_i + P_{i-1}P_{i-2} \dots P_i(G_o + P_o.C_o))$$

(i = 0, l, 2, 3 ...)

and

(b) the remaining gate circuit portion of the carry look-ahead circuit, for calculating at least the remaining propagators $(P_i.P_{i-1} .... P_1 (G_0 + P_0.C_0))$ in accordance with the conditions of $C_0$.

14. The carry look-ahead calculating circuit as claimed in claim 13 wherein said two n-bit numbers are n = 4 bits respectively.

15. The carry look-ahead calculating circuit as claimed in claim 13 wherein the total number of gates in the CLA is 41 gates when n = 4 bits.

16. The carry look-ahead calculating circuit as claimed in claim 13 wherein said two n-bit numbers are n = 16 bits respectively.

17. A carry look-ahead circuit for performing parallel calculations of two n-bit numbers, which comprises:

(a) a common gate circuit portion for calculating each sum of the i-th bit position of the two numbers and generators and propagators of each carry from lower bit positions respectively in accordance with the following equations of

$$C_{i+1} = \overline{\overline{P_i}.\overline{G_i}}.\overline{\overline{P_{i-1}}.\overline{G_i}.\overline{G_{i-1}}.\overline{P_{i-2}}} \cdots \overline{\overline{G_i}.\overline{G_{i-1}} \cdots \overline{G_2 P_1}} \cdot$$

$$\overline{\overline{G_i}.\overline{G_{i-1}} \cdots \overline{G_1}.(\overline{G_0 + P_0.C_0})}$$

$$S_i = (\overline{\overline{P_i}.\overline{G_i}}) \oplus (\overline{\overline{P_{i-1}}.\overline{G_{i-1}}.\overline{P_{i-2}} \cdot \overline{G_{i-1}}.\overline{G_{i-2}}.\overline{P_{i-3}} \cdots$$

$$\overline{\overline{G_{i-1}}.\overline{G_{i-2}} \cdots \overline{G_2 P_1}} \cdot \overline{\overline{G_{i-1}}.\overline{G_{i-2}} \cdots \overline{G_1} \cdot (\overline{G_0 + P_0.C_0}))$$

and

(b) the remaining gate circuit portion of the carry look-ahead circuit, for calculating at least the remaining propagators $(P_i.P_{i-1} ... P_1 (G_0 + P_0. C_0))$ in accordance with the conditions of $C_0$.

0 242 600

FIG.1(a)

FIG.1(b)

# FIG.2

B15~B12  A15~A12    B11~B8  A11~A8    B7~B4  A7~A4    B3~B0  A3~A0

C15 ← [CLA 4] — [CLA 4] — [CLA 4] — $\bar{C}_4$ [CLA 4] C0

Z15~Z12    Z11~Z8    Z7~Z4    Z3~Z0

0 242 600

FIG. 3

# FIG.4(a)

# FIG.4(b)

# F I G. 5 ( a )

# F I G. 5 ( b )

# F I G . 6 ( a )

# F I G . 6 ( b )

# FIG. 7

# FIG.8

# FIG.9

# FIG.10(a)

# FIG.10(b)

# FIG.11(a)

# FIG.11(b)

# FIG.12